Europäisches Patentamt

European Patent Office

Office européen des brevets

(19)

(11) EP 0 617 292 B1

(12) **FASCICULE DE BREVET EUROPEEN**

(45) Date de publication et mention
de la délivrance du brevet:
**11.11.1998 Bulletin 1998/46**

(51) Int Cl.⁶: **G01R 27/16**

(21) Numéro de dépôt: **94420076.5**

(22) Date de dépôt: **08.03.1994**

(54) **Système de contrôle permanent de la conduction électrique d'un réseau alternatif**

System zur ständigen Überwachung der elektrischen Leitfähigkeit eines Wechselstromnetzes

Continuously AC-mains resistance monitoring system

(84) Etats contractants désignés:
**DE ES GB IT**

(30) Priorité: **18.03.1993 FR 9303248**

(43) Date de publication de la demande:
**28.09.1994 Bulletin 1994/39**

(73) Titulaire: **SCHNEIDER ELECTRIC SA**
**92100 Boulogne Billancourt (FR)**

(72) Inventeurs:
• **Gaildrat, Gérard**
**F-38050 Grenoble Cedex 09 (FR)**

• **Allin, Patrice**
**F-38050 Grenoble Cedex 09 (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
**EP-A- 0 199 979**      **EP-A- 0 430 823**
**DE-A- 2 449 016**      **FR-A- 2 386 043**

**Description**

L'invention concerne un système de contrôle permanent de la conduction électrique d'au moins une portion d'un réseau alternatif, comportant au moins un module comportant des moyens de production d'une composante continue de courant entre des premier et second points situés respectivement sur des premier et second conducteurs du réseau, des moyens de mesure de la composante continue de tension appliquée entre ces premier et second points et des moyens de détection d'un défaut de conduction tenant compte de ladite composante continue de tension , les moyens de production d'une composante continue de courant comportant un redresseur contrôlé et des moyens de contrôle du redresseur contrôlé.

Les systèmes connus, notamment celui décrit dans le document EP-A-430.823, ne prennent pas en compte la présence éventuelle de courants continus parasites sur le réseau.

L'invention a pour but un système permettant d'éliminer l'influence de courants continus parasites.

Selon l'invention, ce but est atteint par le fait que les moyens de contrôle du redresseur contrôlé fournissent un signal de blocage du redresseur contrôlé pendant une première période, de durée prédéterminée, d'un cycle de mesure et des signaux de contrôle destinés à produire ladite composante continue de courant pendant une seconde période, de durée prédéterminée, du cycle de mesure, les moyens de mesure de la composante continue de tension comportant des moyens de mesure de première et seconde valeurs respectivement représentatives de ladite composante continue de tension pendant lesdites première et seconde période, et des moyens de calcul de la différence entre les seconde et première valeur, ladite différence étant représentative de la composante continue à mesurer.

Selon un développement de l'invention, le système comporte au moins un module de mesure et un module de rebouclage comportant chacun un redresseur contrôlé, montés en sens inverse, et des moyens de contrôle dudit redresseur contrôlé, les moyens de contrôle des modules de mesure et de rebouclage étant synchronisés de manière à bloquer les redresseurs contrôlés desdits modules pendant la première période .

En faisant la différence entre les composantes continues de tension aux bornes des modules de mesure et de rebouclage, les moyens de mesure des modules de mesure et de rebouclage comportant des moyens d'échantillonnage simultané des tensions à mesurer, il est possible de s'affranchir également des parasites basse fréquence résiduels.

D'autres avantages et caractéristiques ressortiront plus clairement de la description qui va suivre, de modes de réalisations particuliers de l'invention, donnés à titre d'exemple non limitatifs et représentés aux dessins annexés sur lesquels:

La figure 1 illustre schématiquement un système de contrôle de conduction selon l'art antérieur.

La figure 2 représente un module de mesure d'un système selon un mode de réalisation particulier de l'invention.

Les figures 3 et 4 illustrent respectivement les périodes d'injection et de mesure dans un mode particulier de réalisation de l'invention.

La figure 5 représente un organigramme de fonctionnement d'un module d'un système selon l'invention.

La figure 6 représente un autre mode de réalisation de l'invention, comportant des modules de mesure et de rebouclage.

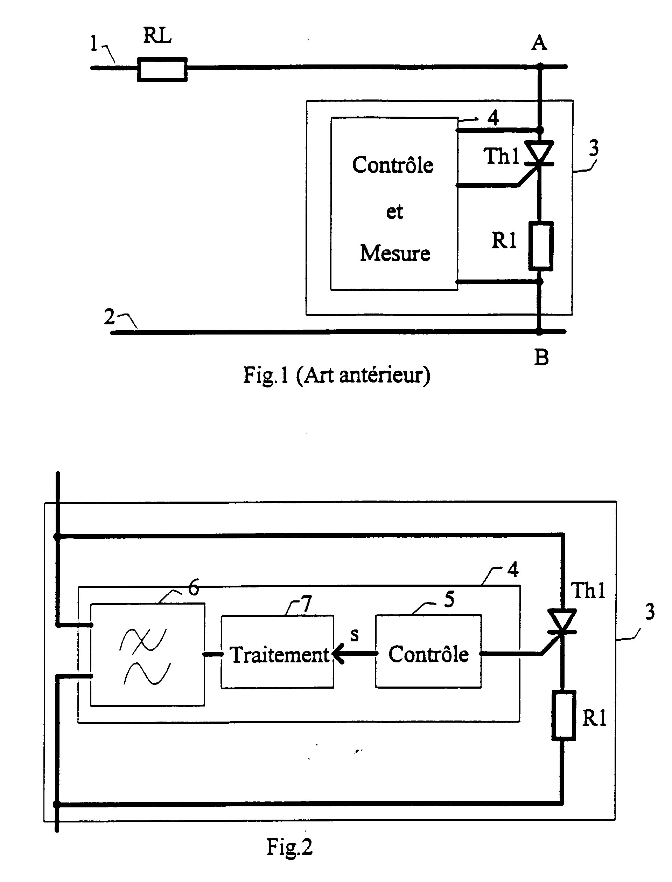

Le système connu représenté à la figure 1 est destiné à contrôler la conduction d'une portion d'un réseau électrique alternatif monophasé, comportant deux conducteurs 1 et 2. Un module de mesure 3 comporte deux bornes connectées à des points A et B, situés respectivement sur chacun des conducteurs 1 et 2. Une résistance RL schématise la résistance de ligne du réseau en amont des points A et B. Le module de mesure 3 comporte des moyens de production d'une composante continue de courant. Sur la figure 1, ces moyens sont constitués par un thyristor Th1 connecté en série avec une résistance R1 entre les bornes du module de mesure 3. Un circuit 4 de contrôle et de mesure fournit des signaux de commande à la gâchette du thyristor Th1, de manière à imposer le passage, dans le module de mesure, d'une composante continue Ic de courant de valeur prédéterminée. Le circuit 4 de contrôle et de mesure est connecté aux bornes du module de mesure de manière à recevoir en entrée la tension appliquée entre les points A et B. Lorsque la composante continue du courant est constante, une variation de la composante continue de la tension entre les points A et B est représentative d'une variation de la résistance de ligne RL en amont des points A et B. Le circuit 4 détecte une augmentation de ladite composante continue de tension, représentative d'une augmentation de la résistance de ligne RL, compare cette augmentation à un seuil prédéterminé et signale un défaut de conduction lorsque le seuil est dépassé.

Le module de mesure 3 est représenté plus en détail à la figure 2. Le circuit 4 de contrôle et de mesure est représenté sous forme de schéma-blocs et comporte un circuit de contrôle 5, un filtre passe-bas 6 et un circuit de traitement 7. La tension aux bornes du module de mesure, est appliquée à l'entrée du filtre passe-bas 6 qui fournit au circuit de traitement 7 une tension représentative de la composante continue de sa tension d'entrée.

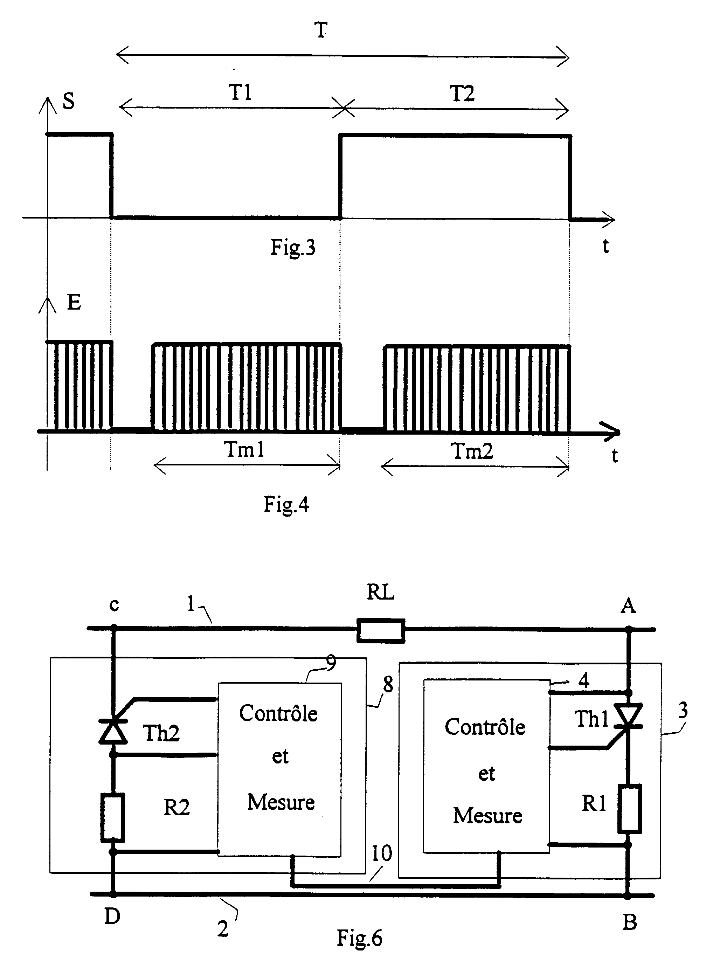

Comme illustré sur la figure 3, un cycle de mesure T, de durée supérieure à une période du réseau, est divisé en deux périodes T1 et T2. Pendant la première période T1, le circuit de contrôle 5 bloque le thyristor Th1. Aucune composante continue de courant n'est alors produite par le module de mesure 3. Pendant la seconde période T2, le circuit de contrôle 5 contrôle l'injection dans le réseau d'une composante continue de

courant lc. Des signaux S de synchronisation, représentés sur la figure 3 en fonction du temps, sont appliqués au circuit de traitement 7 par le circuit de contrôle 5, de manière à fournir au circuit de traitement une information représentative des périodes T1 et T2.

La figure 4 représente des signaux E d'échantillonnage par le circuit de traitement 7 de la composante continue de tension fournie par le filtre 6. Le circuit de traitement 7 réalise un premier échantillonnage pendant une première fenêtre de mesure Tm1, à l'intérieur de la période T1. Un second échantillonnage est réalisé pendant une seconde fenêtre de mesure Tm2, à l'intérieur de la période T2. La fenêtre Tm1 est de durée inférieure ou égale à T1 et la fenêtre Tm2 de durée inférieure ou égale à T2. Dans le mode de réalisation préférentiel représenté à la figure 4, une période de stabilisation (T1 - Tm1 ; T2 - Tm2) est prévue au début de chaque période avant le début de la fenêtre de mesure correspondante.

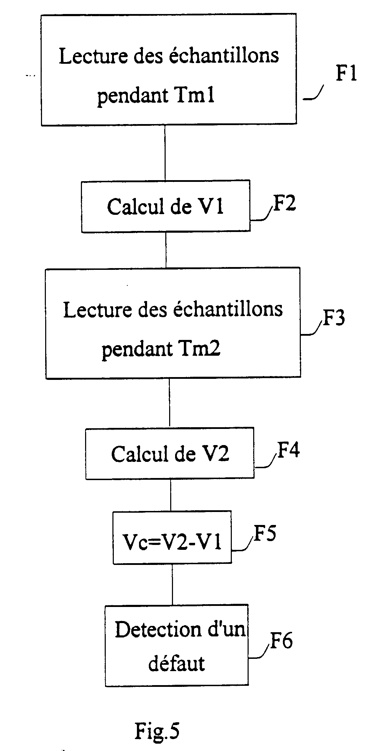

La figure 5 illustre un organigramme de fonctionnement du circuit de traitement 7. Pendant une première étape F1, le circuit 7 lit les échantillons représentatifs de la tension de sortie du filtre 6 pendant la première fenêtre Tm1. Puis, pendant une seconde étape F2, il calcule, à partir de ces échantillons, une première valeur V1, représentative de la valeur de la composante continue de la tension d'entrée du module de mesure 3 pendant la fenêtre Tm1. Le circuit de traitement 7 lit ensuite, pendant une troisième étape F3, les échantillons représentatifs de la tension de sortie du filtre 6 pendant la seconde fenêtre Tm2. Puis, pendant une quatrième étape F4, il calcule une seconde valeur V2, représentative de la valeur de la composante continue de la tension d'entrée du module de mesure 3 pendant la fenêtre Tm2.

Pendant la période T1, en l'absence de composante continue de courant injectée par le module de mesure, la tension continue appliquée aux bornes du module est représentative des composantes continues parasites, ou tensions d'offset, du réseau. Pendant la période T2, une composante continue de courant étant injectée dans le réseau par le module de mesure, la tension continue appliquée aux bornes du module est représentative de la somme des composantes continues parasites et de la composante continue de tension à mesurer Vc pour déterminer la résistance de ligne. La différence V2-V1, calculée par le circuit de traitement 7 pendant une étape F5 est donc représentative de la composante continue Vc à mesurer. Pendant une étape F6, le circuit de traitement détecte la présence éventuelle d'un défaut de conduction en surveillant les variations d'une grandeur représentative de la résistance de ligne, dérivée de la différence Vc = V2 - V1, à laquelle elle est proportionnelle.

Les périodes T1 et T2 sont, de préférence, égales, comme représentées sur la figure 3. A titre d'exemple non limitatif, la période T peut être de l'ordre de quelques secondes, par exemple 10s, les périodes T1 et T2 étant égales à T/2 et les fenêtres Tm1 et Tm2 ayant une durée identique, par exemple de l'ordre de 3s.

Selon un mode de réalisation préférentiel, les valeurs V1 et V2 sont obtenues en faisant la moyenne des échantillons correspondants, respectivement obtenus pendant les fenêtres de mesure Tm1 et Tm2. Grâce à l'utilisation des valeurs moyennes, le circuit de traitement réalise une fonction additionnelle de filtrage qui permet d'éliminer l'essentiel des composantes basses fréquences du réseau.

Pour entraîner une meilleure réjection des parasites basse-fréquence du réseau, il peut être souhaitable de calculer les valeurs V1 et V2 à partir des échantillons correspondants en faisant une moyenne pondérée. Dans ce but, il est possible de remplacer les fenêtres rectangulaires de la figure 4 par des fenêtres sinusoïdales ou de toute autre forme appropriée. Le même type de pondération étant utilisée pour le calcul de V1 et de V2, leur différence reste représentative de la composante continue de tension Vc à mesurer.

La détection d'un défaut peut être effectuée directement par comparaison de la variation de Vc à un seuil prédéterminé. Il est bien entendu possible de calculer la valeur de la résistance de ligne RL, proportionnelle à Vc, et de comparer ses variations à un seuil prédéterminé correspondant pour détecter un défaut. Si, comme dans certains modes de réalisation décrits dans le document EP-A-430.823, la résistance de ligne est obtenue en faisant le rapport de la composante continue Vc et de la composante continue de la tension aux bornes de la résistance R1 ou d'un shunt de mesure, le principe de mesure décrit ci-dessus s'applique également à la mesure de cette dernière tension, qui est filtrée, échantillonnée respectivement pendant les fenêtres Tm1 et Tm2, sa composante continue étant égale à la différence entre les valeurs moyennes, éventuellement pondérées, des échantillons obtenus respectivement pendant les fenêtres Tm2 et Tm1.

Dans le document précité, l'utilisation de modules de rebouclage permet de surveiller une portion de réseau comprise entre les modules de mesure et de rebouclage. Dans ce document, le module de rebouclage peut être du même type que le module de mesure selon la figure 1, le circuit de contrôle et de mesure comportant des moyens d'asservissement à zéro de la composante continue de la tension appliquée à ses bornes d'entrée.

Si le module de mesure utilise le principe de mesure décrit ci-dessus en référence aux figures 3 à 5, le fonctionnement du module de rebouclage éventuellement associé doit être adapté en conséquence. La figure 6 illustre un système selon l'invention permettant de surveiller la conduction d'une portion du réseau comprise entre les points A et B auxquels est connecté le module de mesure 3 et des points C et D, disposés en amont des points A et B, respectivement sur les conducteurs 1 et 2, et auxquels est connecté un module de rebouclage 8.

Le module de rebouclage 8 comporte des moyens de rebouclage de la composante continue de courant produite par le module de mesure 3. Sur la figure 6, un thyristor Th2, connecté en série avec une résistance R2, est connecté entre les points C et D de manière à permettre le passage du courant du conducteur 2 au conducteur 1, soit en sens inverse du thyristor Th1. n comporte un circuit de contrôle et de mesure 9 synchronisé avec le circuit de contrôle et de mesure du module de mesure 3, par exemple par une liaison de synchronisation 10. La synchronisation permet de bloquer simultanément les thyristors Th1 et Th2 pendant la période T1, et de les commander simultanément pendant la période T2. La composante continue de tension Vc (CD) aux bornes du module de rebouclage 8 est mesurée de la même manière que la composante continue de tension Vc (AB) aux bornes du module de mesure 3 et leur différence Vc (AB) - Vc (CD) est représentative de la composante continue de tension aux bornes de la résistance de ligne RL de la portion du réseau considérée.

L'échantillonnage simultané des tensions continues présentes aux bornes des modules de mesure et de rebouclage permet d'éliminer les parasites basse-fréquence résiduels. En effet, les composantes continues mesurées respectivement pendant les fenêtres de mesure Tm1 et Tm2 entre les points A et B et, respectivement, C et D, peuvent se décomposer sous la forme suivante :

$$V1 \text{ (AB)} = Vof\ 1 + Vbf\ 1$$

$$V1 \text{ (CD)} = Vof\ 2 + Vbf\ 1$$

$$V2 \text{ (AB)} = V \text{ (AB)} + Vof\ 1 + Vbf\ 2$$

$$V2 \text{ (CD)} = V \text{ (CD)} + Vof\ 2 + Vbf\ 2$$

où

V1 (AB) et V1 (CD) sont les composantes continues mesurées pendant la fenêtre Tm1, entre A et B et, respectivement, entre C et D.
V2 (AB) et V2 (CD) sont les composantes correspondantes mesurées pendant la fenêtre Tm2.
Vof 1 est la tension d'offset entre A et B, considérée comme constante sur une période T.
Vof 2 est la tension d'offset entre C et D, considérée comme constante sur une période T.
Vbf 1 est le bruit basse fréquence résiduel pendant la période T1 et la fenêtre Tm1.
Vbf 2 est le bruit basse fréquence résiduel pendant la période T2 et la fenêtre Tm2.
V (AB) et V (CD) sont les composantes continues, débarrassées des composantes parasites, à mesurer aux bornes des modules de mesure et de rebouclage.

On peut vérifier que les tensions d'offset sont éliminées lors du calcul respectif des différences Vc (AB) = V2 (AB) - V1 (AB) et Vc (CD) = V2 (CD) - V1 (CD), et que le bruit résiduel est éliminé par le calcul de la différence Vc (AB) - Vc (CD) qui sert de base à la surveillance de la conduction.

L'invention n'est pas limitée aux modes de réalisation particuliers décrits ci-dessus. En particulier, les thyristors peuvent être remplacés par tout type de redresseur contrôlé, et la résistance R1 peut être remplacée par un circuit non dissipatif accordé sur le réseau. Les filtres passe-bas peuvent être analogiques ou numériques. Les circuits de contrôle et de mesure peuvent comporter des microprocesseurs, certains éléments pouvant être communs à plusieurs circuits.

Les circuits de contrôle et de mesure 4 et 9 du système selon la figure 6 peuvent être connectés à un circuit de traitement centralisé qui effectue la différence Vc (AB) - Vc (CD) ou cette différence peut être effectuée dans l'un des modules, qui signale un éventuel défaut de conduction.

Lorsque le système comporte un module de rebouclage, celui-ci doit être synchronisé avec le module de mesure pour bloquer tout passage du courant pendant la période T1. Les thyristors Th1 et Th2 sont de préférence également synchronisés pendant la période T2. Cependant il est envisageable d'asservir à zéro la composante continue de tension aux bornes du module de rebouclage pendant la période T2, la composante continue de tension aux bornes du module de mesure étant alors directement représentative de la résistance de ligne.

Les mêmes principes de mesure sont applicables à un réseau triphasé, les modules étant alors connectés entre deux phases.

## Revendications

1. Système de contrôle permanent de la conduction électrique d'au moins une portion d'un réseau alternatif, comportant au moins un module (3) comportant des moyens (Th1) de production d'une composante continue de courant entre des premier et second points (A, B) situés respectivement sur des premier et second conducteurs (1, 2) du réseau, des moyens (4, 7) de mesure de la composante continue de tension (Vc) appliquée entre ces premier et second points (A, B) et des moyens (4, 7, F6) de détection d'un défaut de conduction tenant compte de ladite composante continue de tension (Vc), les moyens de production d'une composante continue de courant comportant un redresseur contrôlé (Th1) et des moyens (5) de contrôle du redresseur contrôlé, système caractérisé en ce que les moyens (5) de contrôle du redresseur contrôlé (Th1) fournissent un signal de blocage du redresseur contrôlé pendant une première période (T1), de durée prédéterminée, d'un cycle de mesure (T) et des signaux de contrôle destinés à produire ladite composante continue de courant pendant une seconde période (T2), de durée prédéterminée, du cycle de mesure, les moyens de mesure (7) de la composante continue de tension comportant des moyens (F1 à F4) de mesure de première et seconde valeurs (V1, V2) respectivement représentatives de ladite composante continue de tension pendant lesdites première et seconde période, et des moyens (F5) de calcul de la différence (Vc) entre les seconde et première valeur, ladite différence étant représentative de la composante continue (Vc) à mesurer.

2.  Système selon la revendication 1, caractérisé en ce que le cycle de mesure a une durée (T) supérieure à une période du réseau.

3.  Système selon la revendication 2, caractérisé en ce que le cycle de mesure a une durée de l'ordre de 10s.

4.  Système selon l'une quelconque des revendications 1 à 3, caractérisé en ce que les moyens (F1, F2) de mesure de la première valeur (V1) comportent des moyens (F1) d'échantillonnage et de mesure d'échantillons pendant une première fenêtre de mesure (Tm1), de durée inférieure ou égale à la première période (T1).

5.  Système selon l'une quelconque des revendications 1 à 4, caractérisé en ce que les moyens (F3, F4) de mesure de la seconde valeur (V2) comportent des moyens (F3) d'échantillonnage et de mesure d'échantillons pendant une seconde fenêtre de mesure (Tm2), de durée inférieure ou égale à la seconde période (T2).

6.  Système selon l'une quelconque des revendications 4 et 5, caractérisé en ce que les moyens de mesure comportent des moyens (F2, F4) de calcul de la moyenne des échantillons mesurés pendant une fenêtre de mesure.

7.  Système selon l'une quelconque des revendications 4 et 5, caractérisé en ce que les moyens de mesure comportent des moyens de calcul d'une moyenne pondérée des échantillons mesurés pendant une fenêtre de mesure.

8.  Système selon l'une quelconque des revendications 1 à 7, caractérisé en ce qu'il comporte au moins un module de mesure (3) et un module de rebouclage (8) comportant chacun un redresseur contrôlé (Th1, Th2), montés en sens inverse, et des moyens de contrôle (4, 9) dudit redresseur contrôlé, les moyens de contrôle des modules de mesure et de rebouclage étant synchronisés de manière à bloquer les redresseurs contrôlés (Th1, Th2) desdits modules pendant la première période (T1).

9.  Système selon la revendication 8, caractérisé en ce qu'il comporte des moyens de calcul de la différence entre les composantes continues de tension aux bornes des modules de mesure et de rebouclage, les moyens de mesure (4, 9) des modules de mesure et de rebouclage comportant des moyens d'échantillonnage simultané des tensions à mesurer.

10. Système selon l'une quelconque des revendications 1 à 9, caractérisé en ce que le redresseur contrôlé est un thyristor (Th1, Th2).

**Patentansprüche**

1.  Anordnung zur kontinuierlichen Überwachung der Stromleitung in mindestens einem Abschnitt eines Wechselstromnetzes mit mindestens einem Modul (3), welches Mittel (Th1) zur Erzeugung einer Gleichstromkomponente zwischen einem ersten und einem zweiten Punkt (A, B), die jeweils in einem ersten und einem zweiten Leiter (1, 2) des Netzes angeordnet sind, Mittel (4, 7) zur Messung der zwischen diesem ersten und zweiten Punkt (A, B) angelegten Gleichspannungskomponente (Vc) sowie die genannte Gleichspannungskomponente (Vc) berücksichtigende Mittel (4, 7, F6) zur Erfassung eines Stromleitungsfehlers umfaßt, wobei die Mittel zur Erzeugung einer Gleichstromkomponente einen gesteuerten Gleichrichter (Th1) sowie Mittel (5) zur Ansteuerung des gesteuerten Gleichrichters umfassen, dadurch gekennzeichnet, daß die Mittel (5) zur Ansteuerung des gesteuerten Gleichrichters (Th1) während einer ersten Zeitspanne (T1) festgelegter Dauer eines Meßzyklus' (T) ein Signal zum Sperren des gesteuerten Gleichrichters und während einer zweiten Zeitspanne (T2) festgelegter Dauer des Meßzyklus' Steuersignale zur Erzeugung der genannten Gleichstromkomponente liefern, wobei die Mittel (7) zur Messung der Gleichspannungskomponente Mittel (F1 bis F4) zur Messung eines ersten und eines zweiten Werts (V1, V2), welche die genannten Gleichspannungskomponenten der genannten ersten bzw. zweiten Zeitspanne abbilden, sowie Mittel (F5) zur Berechnung der Differenz (Vc) zwischen dem zweiten und dem ersten Wert umfassen und die genannte Differenz die zu messende Gleichspannungskomponente (Vc) abbildet.

2.  Anordnung nach Anspruch 1, dadurch gekennzeichnet, daß die Dauer (T) des Meßzyklus' länger als eine Periodendauer des Netzes ist.

3. Anordnung nach Anspruch 2, dadurch gekennzeichnet, daß der Meßzyklus eine Dauer von etwa 10 s aufweist.

4. Anordnung nach irgendeinem der Ansprüche 1 bis 3, dadurch gekennzeichnet, daß die Mittel (F1, F2) zur Messung des ersten Werts (V1) Mittel (F1) zur Abtastung und Messung der Abtastwerte innerhalb eines ersten Meßfensters (Tm1) umfassen, das im Vergleich zur ersten Zeitspanne (T1) eine kürzere oder identische Dauer aufweist.

5. Anordnung nach irgendeinem der Ansprüche 1 bis 4, dadurch gekennzeichnet, daß die Mittel (F3, F4) zur Messung des zweiten Werts (V2) Mittel (F3) zur Abtastung und Messung der Abtastwerte innerhalb eines zweiten Meßfensters (Tm2) umfassen, das im Vergleich zur zweiten Zeitspanne (T2) eine kürzere oder identische Dauer aufweist.

6. Anordnung nach irgendeinem der Ansprüche 4 und 5, dadurch gekennzeichnet, daß die Meßmittel Mittel (F2, F4) zur Berechnung des Mittelwerts der innerhalb eines Meßfensters gemessenen Abtastwerte umfassen.

7. Anordnung nach irgendeinem der Ansprüche 4 und 5, dadurch gekennzeichnet, daß die Meßmittel Mittel zur Berechnung eines gewichteten Mittelwerts der innerhalb eines Meßfensters gemessenen Abtastwerte umfassen.

8. Anordnung nach irgendeinem der Ansprüche 1 bis 7, dadurch gekennzeichnet, daß sie mindestens ein Meßmodul (3) und ein Rückführmodul (8) umfaßt, die jeweils einen gegensinnig geschalteten, gesteuerten Gleichrichter (Th1, Th2) sowie Mittel (4, 9) zur Ansteuerung des genannten gesteuerten Gleichrichters umfassen, wobei die Ansteuermittel des Meßmoduls und des Rückführmoduls synchronisiert sind, derart daß die gesteuerten Gleichrichter (Th1, Th2) der genannten Module während der ersten Zeitspanne (T1) gesperrt sind.

9. Anordnung nach Anspruch 8, dadurch gekennzeichnet, daß sie Mittel zur Berechnung der Differenz zwischen den Gleichspannungskomponenten an den Klemmen des Meßmoduls und des Rückführmoduls umfassen, wobei die Meßmittel (4, 9) des Meßmoduls und des Rückführmoduls Mittel zur zeitgleichen Abtastung der zu messenden Spannung aufweisen.

10. Anordnung nach irgendeinem der Ansprüche 1 bis 9, dadurch gekennzeichnet, daß der gesteuerte Gleichrichter als Thyristor (Th1, Th2) ausgebildet ist.

**Claims**

1. A system for continuous monitoring of the electrical conduction of at least a portion of an AC power system, comprising at least one module (3) comprising means (Th1) for producing a DC current component between first and second points (A, B) located respectively on first and second conductors (1, 2) of the power system, means (4, 7) for measuring the DC voltage component (Vc) applied between these first and second points (A, B), and means (4, 7, F6) for detecting a conduction fault taking account of said DC voltage component (Vc), the means for producing a DC current component comprising a controlled rectifier (Th1) and means (5) for controlling the controlled rectifier, a system characterized in that the means (5) for controlling the controlled rectifier (Th1) supply a turn-off signal of the controlled rectifier during a first period (T1), of preset duration, of a measuring cycle (T), and control signals designed to produce said DC current component during a second period (T2), of preset duration, of the measuring cycle, the means (7) for measuring the DC voltage component comprising means (F1 to F4) for measuring first and second values (V1, V2) respectively representative of said DC voltage component during said first and second periods, and means (F5) for computing the difference (Vc) between the second and first value, said difference being representative of the DC component (Vc) to be measured.

2. A system according to claim 1, characterized in that the measuring cycle has a duration (T) greater than a period of the power system.

3. A system according to claim 2, characterized in that the measuring cycle has a duration of about 10s.

4. A system according to any one of the claims 1 to 3, characterized in that the means (F1, F2) for measuring the first value (V1) comprise means (F1) for sampling and for measuring samples during a first measurement window (Tm1) of a duration less than or equal to the first period (T1).

5. A system according to any one of the claims 1 to 4, characterized in that the means (F3, F4) for measuring the second value (V2) comprise means (F3) for sampling and for measuring samples during a second measurement window (Tm2) of a duration less than or equal to the second period (T2).

6. A system according to any one of the claims 4 and 5, characterized in that the means for measuring comprise means (F2, F4) for calculating the mean of the samples measured during a measurement window.

7. A system according to any one of the claims 4 and 5, characterized in that the means for measuring comprise means for calculating a weighted mean of the samples measured during a measurement window.

8. A system according to any one of the claims 1 to 7, characterized in that it comprises, at least a measuring module (3) and a loop module (8) each comprising a reverse-mounted controlled rectifier (Th1, Th2), and control means (4, 9) of said controlled rectifier, the control means of the measuring and loop modules being synchronized so as to turn off the controlled rectifiers (Th1, Th2) of said modules during the first period (T1).

9. A system according to claim 8, characterized in that it comprises means for calculating the difference between the DC voltage components at the terminals of the measuring and loop modules, the measuring means (4, 9) of the measuring and loop modules comprising means for simultaneous sampling of the voltages to be measured.

10. A system according to any one of the claims 1 to 9, characterized in that the controlled rectifier is a thyristor (Th1, Th2).

1 — RL

A

Th1

3

Contrôle
et
Mesure

4

R1

2

B

Fig.1 (Art antérieur)

Th1

3

6

7

5

4

Traitement ← s ← Contrôle

R1

Fig.2

Fig.3

Fig.4

Fig.6

Lecture des échantillons pendant Tm1 — F1

Calcul de V1 — F2

Lecture des échantillons pendant Tm2 — F3

Calcul de V2 — F4

Vc=V2-V1 — F5

Detection d'un défaut — F6

Fig.5